# EUROPÄISCHE PATENTSCHRIFT

(11) **EP 0 856 447 B1**
(45) Veröffentlichungstag und Bekanntmachung des Hinweises auf die Patenterteilung: **22.08.2001**
(21) Anmeldenummer: 98100559.8
(22) Anmeldetag: 14.01.1998
(51) Int. Cl.: B60T 8/36

(54) **Steuergerät für ein Antiblockiersystem**
Control device for an antilock braking system
Appareil de commande pour un système de freinage antiblocage

(30) Priorität: 04.02.1997 DE 19704152
(43) Veröffentlichungstag der Anmeldung: 05.08.1998
(73) Patentinhaber: SIEMENS AKTIENGESELLSCHAFT, 80333 München (DE)
(72) Erfinder: Schöttl, Johannes, 93086 Wörth (DE)

(56) Entgegenhaltungen:
- EP-A- 0 520 047
- DE-A- 4 225 358
- DE-A- 4 321 331
- DE-A- 19 518 522

## Beschreibung

Die Erfindung betrifft ein Steuergerät zum Aufsetzen auf einen Ventilblock eines Antiblockiersystems mit einem Leiterbahnträger, auf dem eine elektronische Schaltung zum Steuern der Ventile angeordnet ist und der thermisch mit einer Wand des Ventilblocks gekoppelt wird, sowie ein Verfahren zum Herstellen des Steuergeräts.

Die Patentschrift DE 195 18 518 C1 offenbart ein Steuergerät für ein Antiblockiersystem eines Kraftfahrzeugs, bei dem die von Leistungsbauelementen erzeugte Wärme nach außen abgeführt werden soll. Hierzu wird eine erste Leiterplatte flächig auf einer Seitenwand eines Ventilblocks befestigt, wodurch die durch die Leistungsbauelemente erzeugte Wärme nach außen abgeführt wird. Senkrecht zu der ersten Leiterplatte ist eine zweite Leiterplatte angeordnet, die durch Bonddrähte elektrisch mit der ersten Leiterplatte verbunden ist. Auf dieser zweiten Leiterplatte sind Spulen angeordnet, die die Ventile des Ventilblocks elektromagnetisch betätigen.

Beim Herstellen des Steuergeräts muß der Ventilblock des Antiblockiersystems vom Herstellers des Bremssystems dem Hersteller des elektronischen Steuergeräts zugeliefert werden, da die Leiterplatte mit den Leistungsbauelementen direkt am Ventilblock befestigt werden muß. Ferner sind jeweils separate Prozeßschritte erforderlich, um jede der beiden Leiterplatten zu bestücken und eine elektrische Verbindung zwischen den Leiterplatten herzustellen.

Aus der Patentschrift EP 0 499 670 B1 ist ein Ventilsteuergerät bekannt, das in einem Gehäuse zwei miteinander über Kabel verbundene Leiterplatten aufnimmt, wobei eine Leiterplatte eine elektronische Schaltung und die andere Leiterplatte Ventilspulen aufnimmt. Das Steuergerät wird vom Elektronikhersteller an den Hersteller eines ABS-Bremssystems geliefert, der das Steuergerät lediglich auf einem Ventilblock aufsetzen und befestigen muß.

Zum Herstellen dieses Steuergeräts müssen in separaten Prozeßschritten zwei Leiterplatten gehandhabt, in ein verhältnismäßig aufwendiges Gehäuse eingebracht, mit den Ventilspulen, einem Stecker und untereinander verbunden werden. Es ist ein nachträgliches Löten im Gehäuse notwendig, das Freiräume erfordert, die nicht bestückt werden können. Für die Abdichtung des Gehäuses und das Abdecken der Leiterplatte gegenüber dem Motorraum ist ein zusätzlicher Kunststoffdeckel erforderlich, der mit einer Flüssigkeitsdichtung abgedichtet und ausgehärtet werden muß. Zum Druckausgleich im Volumen zwischen der Leiterplatte und dem Gehäusedeckel muß in der Regel ein Druckausgleichselement montiert werden.

Es ist ein Ziel der Erfindung, ein Steuergerät zum Aufsetzen auf einen Ventilblock eines Antiblockiersystems, das sich besonders effizient fertigen läßt, und ein Verfahren zur Herstellung desselben bereitzustellen.

Dieses Ziel wird mit einem Steuergerät und einem Verfahren, wie sie in den unabhängigen Ansprüchen definiert sind, erreicht. Zweckmäßige Weiterbildungen der Erfindung sind in den Unteransprüchen angegeben.

Die einstückige Ausbildung des Leiterbahnträgers ermöglicht, daß der Leiterbahnträger, bevor er mit einem Gehäuse versehen wird, vollständig bestückt und gelötet werden kann. Es ist kein weiterer Lötschritt zum Einbau in ein Gehäuse bzw. zum Herstellen eines elektrischen Kontakts mit den Ventilspulen notwendig. Bereits nach dem Löten der Bauelemente auf den Leiterbahnträger und vor dem Versehen mit einem Gehäuseteil (31) kann ein Funktionstest durchgeführt werden, der die Ventilspulen (12) umfaßt.

Weitere Vorteile, Merkmale und Anwendungsmöglichkeiten der Erfindung ergeben sich aus der nachfolgenden Beschreibung der Ausführungsbeispiele in Verbindung mit den Zeichnungen. Es zeigen:
- Figur 1:: Einen vollständig bestückten Leiterbahnträger, bevor er mit einem Gehäuse versehen wird;
- Figur 2:: einen Ventilblock und den Leiterbahnträger von Figur 1 nachdem er mit einem Gehäuse versehen wurde;
- Figur 3:: das auf den Ventilblock von Figur 2 montierte Steuergerät;
- Figur 4:: einen Spulenblock;
- Figur 5:: einen Leiterbahnträger zum Aufsetzen auf einen L-förmigen Ventilblock aufgesetzt wird; und
- Figur 6:: einen L-förmigen Ventilblock.

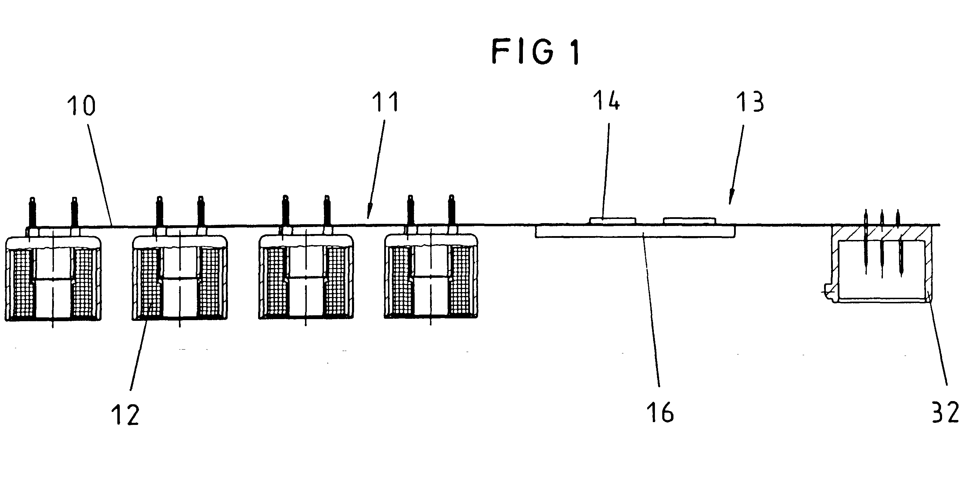

In Figur 1 ist ein vollständig bestückter Leiterbahnträger 10 nach dem Bestücken sämtlicher elektronischer Bauelemente, einschließlich der aktiven elektronischen Bauelemente 14 und der passiven elektronischen Bauelemente wie Ventilspulen 12 und Steckerleiste 32 dargestellt. Der Leiterbahnträger 10 ist eine durchgehend flexible Leiterplatte, die im Bereich der aktiven elektronischen Bauelemente 14 oder Leistungsbauteile an ihrer nicht bestückten Unterseite mit einer wärmeleitenden Platte 16 aus Aluminium versehen ist. Als Leiterplatte ist eine grüne (ungebrannte) flexible Keramikfolie (Low Temperature Cofired Ceramics, LTCC) geeignet. Das Bestücken der Bauelemente wird durch das vorherige Anbringen der wärmeleitenden Platte an der flexiblen Leiterplatte vereinfacht.

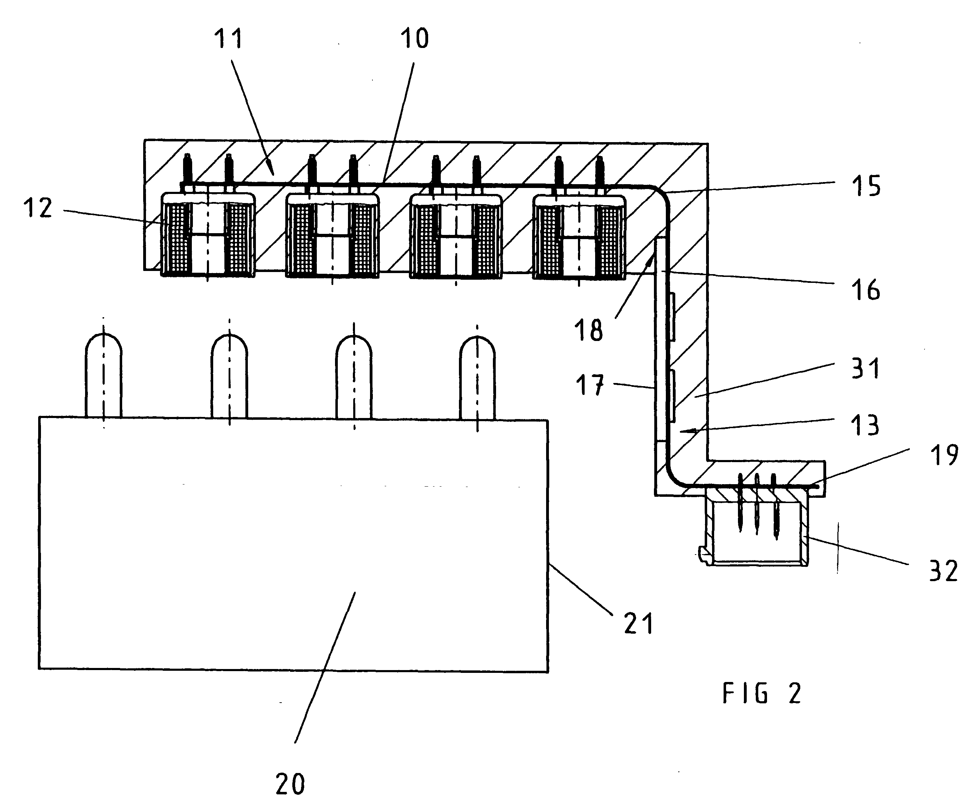

In Figur 2 ist ein Steuergerät 30 vor dem Anbringen auf einem Ventilblock 20 veranschaulicht. Die Leiterplatte ist in einem als flexibel Zone ausgebildeten Abschnitt 15 gebogen, so daß ein erster Bereich 11, der die Ventilspulen 12 aufweist, in einem Winkel von mindestens 30° und höchstens 120° zu einem zweiten Bereich 13 angeordnet ist, der mit aktiven Bauelementen 14 bestückt ist und keine Ventilspulen aufweist. Wie dargestellt, stehen die Bereiche 11 und 13 bevorzugt senkrecht zueinander.

Zur Bildung eines Gehäuses 31 des Steuergeräts 30 wird die gebogene Leiterplatte in eine Form eingelegt und mit Kunststoff, beispielsweise mit Polyurethan (PU) umschäumt oder umspritzt. Dadurch ist das Steuergerät ohne weitere Dichtungsmaßnahmen auf der vom Ventilblock abgewandten Seite hermetisch nach außen abgedichtet. Zudem verschließt das Gehäuse, gegebenenfalls zusammen mit der Leiterplatte, nach dem Montieren des Steuergeräts auf den Ventilblock letzteren nach außen.

Die Wärmeabfuhr von den aktiven elektronischen Bauelemente 14 erfolgt über einen flächigen Kontakt der Leiterplatte 10 mit einer Wand 21 des Ventilblocks 20. Der flächige Kontakt mit der Wand 21 des Ventilblocks wird über die wärmeleitende Platte 16 hergestellt. Diese wärmeleitende Aluplatte kann sehr dünn ausgebildet werden, da die Wärmeabfuhr direkt an den metallischen Ventilblock erfolgt.

Dabei erstreckt sich die wärmeleitende Platte über einen Abschnitt 17, der in Kontakt mit der Wand 21 des Ventilblocks gelangt, hinaus in einen Abschnitt 18, der an den ersten Bereich 11 der Leiterplatte angrenzt. Daher kann auch dieser Abschnitt 18, der nicht unmittelbar in Kontakt mit der Wand 21 des Ventilblocks steht, Leistungsbauelemente aufnehmen. Der Aufbau des Steuergeräts kann deswegen besonders kompakt gehalten werden.

Ein Randbereich 19 des zweiten Bereichs 13 der Leiterplatte ist parallel zum ersten Bereich 11 der Leiterplatte, der die Ventilspulen 12 aufnimmt, in Richtung vom Ventilblock 20 weggebogen, um eine Steckerleiste 32 aufzunehmen. Bei dieser Steckerleiste handelt es sich um eine Einzelmesserleiste. Eine bislang übliche, aufwendig in das Gehäuse integrierte Messerleiste, die erst beim Einsetzen der Leiterplatte in das Gehäuse angelötet wird, entfällt.

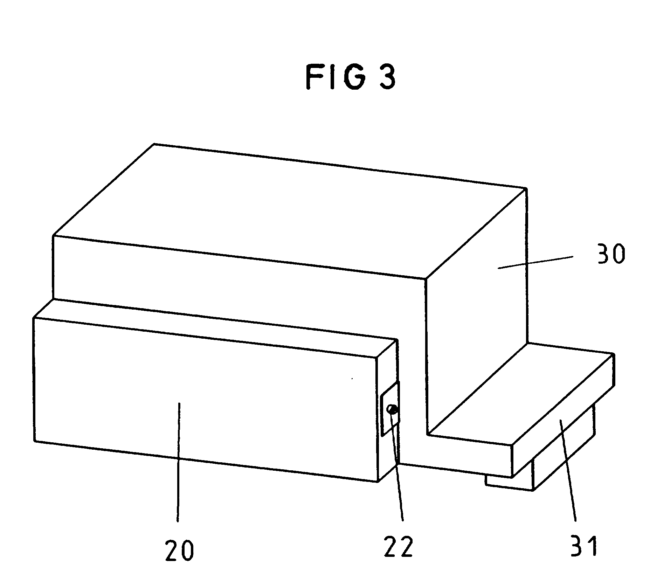

Figur 3 veranschaulicht das auf dem Ventilblock 20 mittels Schrauben 22 befestigte Steuergerät 30. Hierbei wird die wärmeleitende Platte 16 unmittelbar mit dem Ventilblock 20 verbunden, um eine gute Wärmeabfuhr zu gewährleisten.

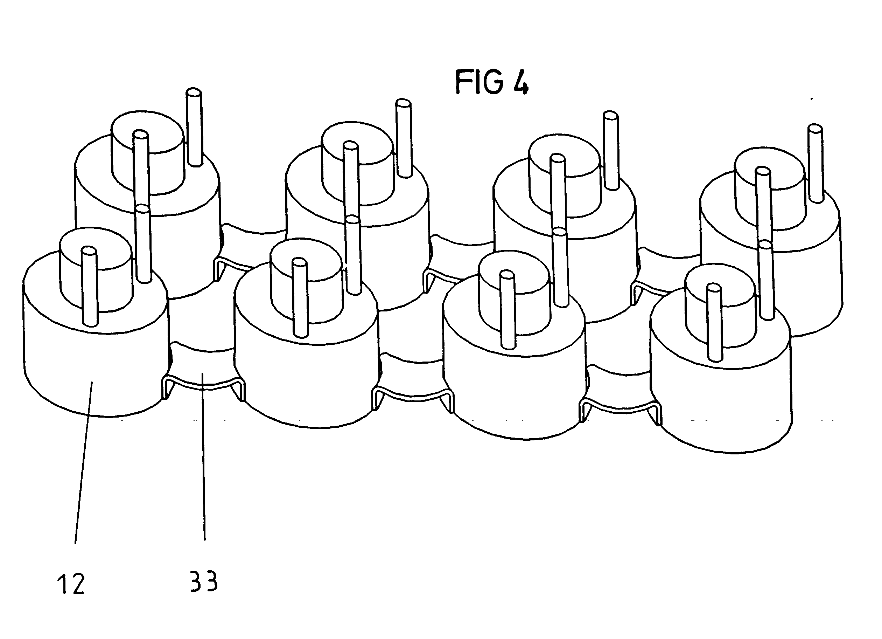

Wie in Figur 4 dargestellt ist, können die Ventilspulen 12 vor dem Bestücken der Leiterplatte 10 zu einem Block 34 zusammengefaßt werden. Hierzu wird Kunststoff an die Spulen 12 angespritzt. Dieser Kunststoff bildet ein flexible Verbindung 33 zwischen den Ventilspulen 12, so daß die Spulen in X-, Y-und Z-Richtung eine gewisse Beweglichkeit aufweisen, um bei der Montage des Steuergeräts 30 auf den Ventilblock 20 Fertigungstoleranzen des Ventilblocks auszugleichen. Die flexible Verbindung ist als gewölbtes Kunststoffbändchen dargestellt.

Der Spulenblock 34 und die Steckerleiste 32 werden in die von einem Werkstückträger aufgenommenen Leiterplatte 10 gesteckt. Der vorher erfolgte Lotpastendruck stellt auch für die durchkontaktierten Lötstellen soviel Lotdepot zur Verfügung, daß eine Lötung zuverlässig erfolgen kann.

Die komplett bestückte Leiterplatte 10 wird in einem Reflow-Ofen gelötet. Hierzu ist es erforderlich, daß die Spulen 12 bzw. die Steckerleiste 32 aus einem Kunststoff hergestellt sind, der für die im Lötofen entstehenden Temperaturen geeignet ist, wie z. B. Polycarbonattherephthalat (PCT). Nach dem Löten kann die Baugruppe komplett geprüft werden.

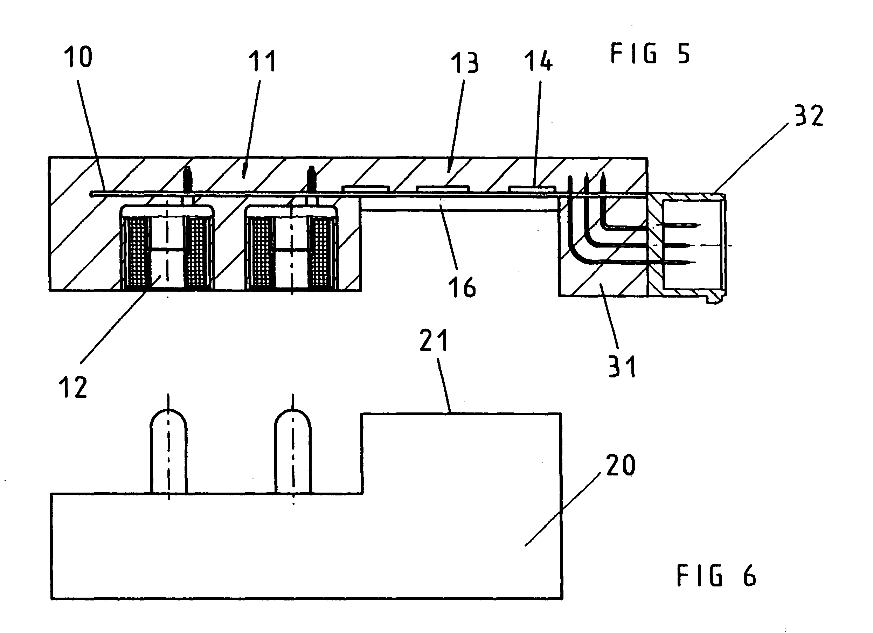

Figur 5 zeigt das an eine fertig bestückte und gelötete Leiterplatte angeschäumte Gehäuse 31 in einer Schnittansicht, bevor es an dem in Figur 6 dargestellten L-förmig ausgebildeten Ventilblock 20 befestigt wird.

Die Leiterplatte 10 bildet eine im wesentlichen ebene Fläche, die im mit aktiven elektronischen Bauelementen bestückten Bereich 13 mit der Oberfläche 21 eines Vorsprungs des Ventilblocks thermisch gekoppelt ist. Obgleich die Leiterplatte auch in unmittelbarem Kontakt mit der Oberfläche des Ventilblocks angebracht sein kann, ist eine wärmeleitende Platte 16 zwischen der Ventilblockoberfläche 21 und dem Leiterbahnträger 10 vorgesehen. Dadurch ist es grundsätzlich möglich die Kontaktoberfläche 21 relativ schmal zu halten. Der Stekker 32 ist parallel zur Leiterplatte ausgerichtet.

## Patentansprüche

1. Steuergerät zum Aufsetzen auf einen Ventilblock eines Antiblockiersystems mit einem Leiterbahnträger (10), auf dem eine elektronische Schaltung zum Steuern von Ventilen angeordnet ist und der thermisch mit einer Wand (21) des Ventilblocks (20) zu koppeln ist,
**dadurch gekennzeichnet, daß** der Leiterbahnträger (10)
- einstückig ausgebildet ist,
- einen ersten Bereich (11) aufweist, der mit Ventilspulen (12) zur Betätigung der Ventile des Ventilblocks bestückt ist,
- einen zweiten Bereich (13) aufweist, der mit aktiven elektronischen Bauelementen (14) bestückt und frei von Ventilspulen ist, und
- ein Gehäuseteil (31) aus angeschäumtem oder angespritztem Kunststoff aufweist, das auf dem Ventilblock (20) befestigbar ist.

2. Steuergerät nach Anspruch 1, dadurch gekennzeichnet, daß der Leiterbahnträger (10) wenigstens in der Zone (15) zwischen dem ersten und dem zweiten Bereich (11, 13) flexibel ist, und daß der erste Bereich (11) und der zweite Bereich (13) des Leiterbahnträgers in einem Winkel zwischen 30° und 120° zueinander angeordnet sind.

3. Steuergerät nach einem der vorhergehenden Ansprüche, dadurch gekennzeichnet, daß eine wärmeleitende Platte (16) in dem Bereich (13) des Leiterbahnträgers, der nicht mit Ventilspulen (12) bestückt ist, derart angebracht ist, daß die wärmeleitende Platte nach der Montage des Steuergerätes (30) auf dem Ventilblock (20) in Kontakt mit der Wand (21) des Ventilblocks gelangt.

4. Steuergerät nach dem vorhergehenden Anspruch, dadurch gekennzeichnet, daß aktive Bauelemente (14) auf dem Abschnitt (18) des zweiten Bereichs (13) des Leiterbahnträgers (10) angeordnetes sind, der sich über die Wand (21) des Ventilblocks hinaus erstreckt.

5. Steuergerät nach einem der vorhergehenden Ansprüche, dadurch gekennzeichnet, daß der Leiterbahnträger einen sich an den von Ventilspulen freien zweiten Bereich (13) anschließenden Randbereich (19) aufweist, in dem ein Stecker oder eine Buchse (32) angebracht ist, wobei der Randbereich (19) im wesentlichen senkrecht zum zweiten Bereich (13) des Leiterbahnträgers angeordnet ist.

6. Verfahren zur Herstellung eines Steuergeräts zum Aufsetzen auf einen Ventilblock eines Antiblockiersystems mit den Schritten:
- ein Leiterbahnträger (10) wird mit elektronischen Bauelementen (12, 14) bestückt, wobei ein Bereich (11) des Leiterbahnträgers mit Ventilspulen (12) bestückt wird,
- die Ventilspulen (12) werden zunächst zusammen mit den übrigen elektronischen Bauelementen an den Leiterbahnträger gelötet und erst anschließend zusammen mit dem Leiterbahnträger (10) mit einem Gehäuseteil (31) versehen.

7. Verfahren nach dem vorhergehenden Anspruch, dadurch gekennzeichnet, daß die für einen Leiterbahnträger (10) bestimmten Ventilspulen (12) zu einem Block zusammengefaßt und gemeinsam auf den Leiterbahnträger gegeben werden.

8. Verfahren nach einem der vorhergehenden Verfahrensansprüche, dadurch gekennzeichnet, daß der Leiterbahnträger durch Umschäumen oder Umspritzen mit einem Kunststoffgehäuseteil (31) versehen wird.

9. Verfahren nach einem der vorhergehenden Verfahrensansprüche, dadurch gekennzeichnet, daß der vollständig bestückte Leiterbahnträger (10) wenigstens eine flexible Zone (15) aufweist, entlang der der Leiterbahnträger gebogen wird, und daß der gebogene Leiterbahnträger in eine Vergußform oder in ein Gehäuseteil (31) eingebracht wird.

## Claims

1. Control unit to be fitted onto a valve block of an anti-blocking system with a conductor track carrier (10), on which an electronic circuit for controlling valves is arranged and which is to be thermally coupled to a wall (21) of the valve block (20), characterized in that the conductor track carrier (10)
- is constructed in one piece,
- has a first region (11) which is equipped with valve coils (12) for activating the valves of the valve block,
- has a second region (13) which is equipped with active electronic components (14) and is free of valve coils, and
- has a housing part (31) made of plastic which is foamed on or injection moulded on and which can be attached to the valve block (20).

2. Control unit according to Claim 1, characterized in that the conductor track carrier (10) is flexible at least in the zone (15) between the first and second regions (11, 13), and in that the first region (11) and the second region (13) of the conductor track carrier are arranged at an angle of between 30° and 120° with respect to one another.

3. Control unit according to one of the preceding claims, characterized in that a heat-conducting plate (16) is mounted in the region (13) of the conductor track carrier which is not equipped with valve coils (12), in such a way that the heat-conducting plate comes into contact with the wall (21) of the valve block after the control unit (30) is mounted on the valve block (20).

4. Control unit according to the preceding claim, characterized in that active components (14) are arranged on the section (18) of the second region (13) of the conductor track carrier (10) which extends beyond the wall (21) of the valve block.

5. Control unit according to one of the preceding claims, characterized in that the conductor track carrier has an edge region (19) which adjoins the second region (13) free of valve coils and in which a plug or a socket (32) is mounted, the edge region (19) being arranged essentially perpendicularly with respect to the second region (13) of the conductor track carrier.

6. Method for manufacturing a control unit to be fitted on to a valve block of an anti-blocking system having the steps:
- a conductor track carrier (10) is equipped with electronic components (12, 14), one region (11) of the conductor track carrier being equipped with valve coils (12),
- the valve coils (12) are initially soldered to the conductor track carrier together with the other electronic components and only then provided, together with the conductor track carrier (10), with a housing part (31).

7. Method according to the preceding claim, characterized in that the valve coils (12) which are intended for a conductor track carrier (10) are combined to form a block and are placed together on the conductor track carrier.

8. Method according to one of the preceding method claims, characterized in that the conductor track carrier is provided with a plastic housing part (31) by encapsulation by foaming or injection moulding.

9. Method according to one of the preceding method claims, characterized in that the completely equipped conductor track carrier (10) has at least one flexible zone (15) along which the conductor track carrier is bent, and in that the bent conductor track carrier is placed in a casting mould or in a housing part (31).

## Revendications

1. Appareil de commande à installer sur un bloc de vannes d'un système de freinage antiblocage, comportant un support (10) de conducteurs imprimés, sur lequel est disposé un montage électronique pour commander des vannes et qui peut être couplé thermiquement à une paroi (21) du bloc (20) de vannes,
caractérisé en ce que le support (10) de conducteurs imprimés
- est réalisé d'un seul tenant,
- comporte une première région (11) qui est équipée de bobines (12) d'électrovannes pour actionner les vannes du bloc de vannes,
- comporte une deuxième région (13) qui est équipée de composants (14) électroniques actifs et est dépourvue de bobines d'électrovannes, et
- comporte un élément (31) de boîtier en matière plastique moussée ou injectée, qui peut être fixé sur le bloc (20) de vannes.

2. Appareil de commande suivant la revendication 1, caractérisé en ce que le support (10) de conducteurs imprimés est flexible au moins dans la zone (15) entre la première région (11) et la deuxième région (13), et en ce que la première région (11) et la deuxième région (13) du support de conducteurs imprimés sont disposées l'une par rapport à l'autre sous un angle compris entre 30° et 120°.

3. Appareil de commande suivant l'une des revendications précédentes, caractérisé en ce qu'une plaque (16) thermoconductrice est installée, dans la région (13) du support de conducteurs imprimés qui n'est pas équipée de bobines (12) d'électrovannes, de telle sorte que la plaque thermoconductrice, à la suite du montage de l'appareil (30) de commande sur le bloc (20) de vannes, entre en contact avec la paroi (21) du bloc de vannes.

4. Appareil de commande suivant la revendication précédente, caractérisé en ce que des composants (14) actifs sont disposés sur la partie (18) de la deuxième région (13) du support (10) de conducteurs imprimés qui s'étend au-delà de la paroi (21) du bloc de vannes.

5. Appareil de commande suivant l'une des revendications précédentes, caractérisé en ce que le support de conducteurs imprimés comporte une région (19) de bord, qui se raccorde à la deuxième région (13) dépourvue de bobines d'électrovannes et dans laquelle est installé un connecteur (32) mâle ou femelle, la région (19) de bord étant disposée essentiellement perpendiculairement à la deuxième région (13) du support de conducteurs imprimés.

6. Procédé de fabrication d'un appareil de commande à installer sur un bloc de vannes d'un système de freinage antiblocage, comprenant les étapes suivantes :
- un support (10) de conducteurs imprimés est équipé de composants (12, 14) électroniques, une région (11) du support de conducteurs imprimés étant équipée de bobines (12) d'électrovannes,
- les bobines (12) d'électrovannes sont d'abord brasées sur le support de conducteurs imprimés conjointement avec les autres composants électroniques et pourvues seulement ensuite, conjointement avec le support (10) de conducteurs imprimés, d'un élément (31) de boîtier.

7. Procédé suivant la revendication précédente, caractérisé en ce que les bobines (12) d'électrovannes prévues pour un support (10) de conducteurs imprimés sont réunies en un bloc et conjointement installées sur le support de conducteurs imprimés.

8. Procédé suivant l'une des revendications précédentes de procédé, caractérisé en ce que le support de conducteurs imprimés est pourvu d'un élément (31) de boîtier en matière plastique en l'enrobant par moussage ou par injection.

9. Procédé suivant l'une des revendications précédentes de procédé, caractérisé en ce que le support (10) de conducteurs imprimés totalement équipé comporte au moins une zone (15) flexible, le long de laquelle le support de conducteurs imprimés est recourbé, et en ce que le support recourbé de conducteurs imprimés est introduit dans un moule de scellement ou dans un élément (31) de boîtier.
